Europäisches Patentamt

European Patent Office

Office européen des brevets

(11) Veröffentlichungsnummer: **0 311 970**
**A2**

# (12) EUROPÄISCHE PATENTANMELDUNG

(21) Anmeldenummer: 88116839.7

(22) Anmeldetag: **11.10.88**

(51) Int. Cl.⁴: **H05K 1/03 , H05K 3/20**

(30) Priorität: **16.10.87 DE 3735109**

(43) Veröffentlichungstag der Anmeldung:
**19.04.89 Patentblatt 89/16**

(84) Benannte Vertragsstaaten:
**BE DE FR GB NL SE**

(71) Anmelder: **BASF Aktiengesellschaft**
**Carl-Bosch-Strasse 38**
**D-6700 Ludwigshafen(DE)**

(72) Erfinder: **Buchert, Hermann, Dr.**
**An der Nolzeruhe 8 c**
**D-6702 Bad Duerkheim(DE)**
Erfinder: **Zeiner, Hartmut, Dr.**
**Johann-Strauss-Strasse 13**
**D-6831 Plankstadt(DE)**
Erfinder: **Winkler, Matthias, Dr.**
**Heinigstrasse 24**
**D-6700 Ludwigshafen(DE)**

(54) **Leiterplatte.**

(57) Leiterplatten bestehend aus isolierendem Material und damit verbundenen Leiterbahnen. Das isolierende Material ist aus einem thermoplastischen Fasergebilde (1) und einer dieses beschichtenden, thermoplastischen Folie (2) hergestellt. Die Leiterbahnen (4) sind mit dem isolierenden Material durch thermisches Verpressen verbunden.

EP 0 311 970 A2

## Leiterplatte

Die Erfindung betrifft eine Leiterplatte aus isolierendem Material und damit verbundenen Leiterbahnen.

Leiterplatten wurden bisher vorwiegend aus epoxidharzgetränkten Glasgeweben oder phenolharzgetränktem Papier oder Polyetherketon- bzw. Polyimidfolie hergestellt. Die Leiterbahnen sind darauf durch Negativ- oder Positivverfahren, wie ätztechnische Verfahren, chemische bzw. elektrochemische Metallabscheidung auf sensibilisierten Bahnen oder Aufdampf-Verfahren, aufgebracht. Es wurden auch spritzgegossene Leiterplatten entwickelt, die vorwiegend für dreidimensionale Bauelemente bzw. für den Einsatz als Gerätebauteil gedacht sind. Sie sollen die Integration der Leiterplatten in andere Gerätebauteile ermöglichen und somit eine weitere Miniaturisierung und weitere Kostenreduktionen bei elektrischen und elektronischen Bauteilen ermöglichen.

Leiterplatten aus duroplastischen Materialien können nicht die Funktion von Bauelementen mit übernehmen, da ihre mechanischen Eigenschaften oft unzureichend und ihre Verformung unmöglich ist. Löcher für die Durchführung von Leiterbahnen durch die Leiterplatte müssen gebohrt werden, ein teures Verfahren, das dann zu aufwendigen Nachbesserungen führt, wenn die Durchmesser der Löcher infolge abgenutzter Bohrer außerhalb des Maßtoleranzbereiches liegen. Der automatisierte Bestückungsprozeß muß dann unterbrochen werden. Es entstehen Produktionsausfälle und Mehrkosten, insbesondere, da die Nachbesserungen manuell durchgeführt werden müssen.

Die bekannten Verfahren zur Herstellung von Leiterplatten sind aufwendig, insbesondere nutzt das Negativverfahren die eingesetzten Materialien, wie Kupfer usw. nur mit geringer Ausbeute.

Demgemäß bestand die Aufgabe, eine Leiterplatte und ein Herstellverfahren dafür zu entwickeln, die sich gegenüber den bekannten Platten durch bessere mechanische Eigenschaften und geringeren Herstellaufwand sowie eine bessere Anpassungsfähigkeit an den jeweiligen Einsatzfall auszeichnen.

Die Aufgabe wurde durch eine Leiterplatte gelöst, bei der das isolierende Material aus einem thermoplastischen Fasergebilde besteht, das an mindestens einer seiner beiden Oberflächen mit einer thermoplastischen Folie überzogen ist, und die Leiterbahnen mit dem isolierenden Material durch thermisches Verpressen verbunden sind. Die auf den herstellungstechnischen Teil der Aufgabe sich beziehende Lösung besteht darin, daß ein thermoplastisches Fasergebilde an mindestens einer Oberfläche mit einer thermoplastischen Folie überzogen wird, darauf Leiterbahnen angeheftet werden und die gesamte Anordnung durch thermisches Verpressen geformt und verfestigt wird.

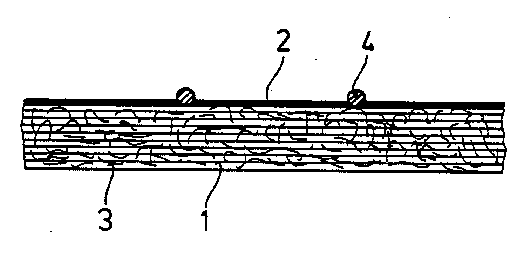

Die Erfindung ist anhand eines in der Zeichnung schematisch dargestellten Ausführungsbeispiels nachfolgend ausführlich beschrieben.

Zur erfindundungsgemäßen Herstellung der Leiterplatten aus isolierendem Material werden Flächengebilde aus Geweben, Vliesen oder Filz 1 aus thermoplastischen Fasern oder Filamenten an mindestens einer der beiden Oberflächen mit einer dünnen thermoplastischen Folie 2 beschichtet. Die Fasergebilde können zusätzlich weitere Fasern 3, wie Glasfasern, Graphitfasern, Aramidfasern, Polyacrylnitrilfasern, zur Verbesserung ihrer mechanischen, thermischen und elektrischen Eigenschaften enthalten. Die Mengenverhältnisse bewegen sich zwischen 10 % bis 100 % Thermoplastfasern und 90 % bis 0 % anorganischen bzw. organischen, nichtthermoplastische Fasern. Die vielfältigen Möglichkeiten der Gestaltung der Fasergebilde, wie Web- bzw. Wirkmuster, erlauben eine weitestgehende Anpassung an die Anforderungen der Formgebung. Auch Mischgewebe, wie Gewebe aus Hybridfasern bzw. Hybridgarnen, Vliese und Filze aus Fasergemischen sowie schichtenförmige Anordnungen von thermoplastischen Geweben, Vliesen, Filzen und entsprechenden Gebilden aus verstärkenden Fasern können eingesetzt werden. Besonders vorteilhaft ist die Möglichkeit, dreidimensionale Leiterplatten aus Hybridgarnen und Mischgeweben herzustellen.

Als Leiterbahnen 4 werden vorzugsweise dünne Kupferdrähte auf der Fasergebilde 1 und Folie 2 enthaltenden Anordnung in gewünschtem Verlauf durch Aufkleben, vorzugsweise aber Anheften oder Aufnähen, provisorisch befestigt. Das Anheften oder Aufnähen erlaubt eine Fadenreserve, so daß beim nachfolgenden Formen und Pressen der gesamten Anordnung Leitermaterial aus den Fadenschlingen nachgezogen werden kann.

Die vorstehend beschriebene, gesamte Anordnung, die Leiterbahnen im gewünschten Verlauf trägt, wird dann durch Pressen oder Thermoformen bei einer Temperatur, die über der Glasübergangstemperatur des thermoplastischen Fasermaterials liegt, und einem Druck zwischen 1 und 100 bar in die gewünschte Form gebracht. Bei diesem Vorgang werden die Leiterbahnen mit der Oberfläche der Platte verbunden und in dieser eingebettet und das Plattengebilde verfestigt.

Bei der Formung können zur Befestigung von elektronischen und mechanischen Bauelementen gleichzeitig Löcher in die Platte eingebracht werden.

Zur Herstellung mehrschichtiger bzw. dreidimensionaler Leiterplatten können abwechselnd Lagen aus thermoplastischem Fasergebilde 1 und Kupferfolie 3 angeordnet werden. Dabei können unter Zwischenlage von Folien 2 und darauf angebrachten Leiterbahnen 4 mehrere Leiterbahnebenen vorgesehen werden, zwischen denen durch durchkontaktierte Bohrungen Verbindungen herstellbar sind.

Eine weitere Möglichkeit, mehrschichtige Platten herzustellen, kann darin bestehen, daß mehrere gepreßte und geformte Einfachplatten aufeinandergelegt zu einem Verbund verpreßt werden.

Die Rückseite der fertigen Leiterplatte kann mit einer isolierenden oder dekorativen Deckschicht versehen sein.

Bei der Herstellung der vorstehend beschriebenen Leiterplatten werden keine Chemikalien eingesetzt, so daß an die Chemikalienbeständigkeit des Plattenmaterials keine besonderen Anforderungen gestellt und für das Herstellverfahren keine Maßnahmen gegen Umweltbelastungen getroffen zu werden brauchen.

Die Auswahl eines geeigneten Thermoplasten richtet sich nach den Anforderungen bei der Verarbeitung der Leiterplatten und deren Einsatz, z.B. nach der Lötbadtemperatur bei der Bestückung mit elektronischen Bauelementen. Dabei können hohe Füllstoffgrade hinsichtlich der Materialkosten und der Wärmekapazität des Plattenmaterials vorteilhaft sein. Bei hohen Lötbadtemperaturen und kurzen Lötzeiten sind Platten mit hoher Wärmekapazität günstig, da sie den Einsatz von Thermoplasten mit relativ niedrigen Glasübergangstemperaturen bzw. Schmelztemperaturen erlauben, die in ungefülltem Zustand, d.h. wegen ihrer geringen Wärmekapazität, zu rasch plastiziert und damit deformierbar werden würden.

## Ansprüche

1. Leiterplatte aus isolierendem Material und damit verbundenen Leiterbahnen, dadurch gekennzeichnet, daß das isolierende Material aus einem thermoplastischen Fasergebilde (1) besteht, das an mindestens einer seiner beiden Oberflächen mit einer thermoplastischen Folie (2) überzogen ist, und die Leiterbahnen (4) mit dem isolierenden Material durch thermisches Verpressen verbunden sind.

2. Leiterplatte nach Anspruch 1, dadurch gekennzeichnet, daß das thermoplastische Fasergebilde (1) anorganische und/oder organische, nichtthermoplastische Fasern (3) enthält.

3. Leiterplatte nach Anspruch 1 und 2, dadurch gekennzeichnet, daß das isolierende Material abwechselnd Lagen aus thermoplastischem Fasergebilde (1) und anorganischen Fasergebilde (3) enthält.

4. Leiterplatte nach Anspruch 1 bis 3, gekennzeichnet durch mehrere Lagen von Leiterbahnen (4).

5. Verfahren zur Herstellung von Leiterplatten nach den Ansprüchen 1 bis 4, dadurch gekennzeichnet, daß ein thermoplastisches Fasergebilde an mindestens einer Oberfläche mit einer thermoplastischen Folie überzogen wird, darauf Leiterbahnen angeheftet werden und die gesamte Anordnung durch thermisches Verpressen geformt und verfestigt wird.

6. Verfahren nach Anspruch 5, dadurch gekennzeichnet, daß mehrere solcher Anordnungen zu einer mehrlagigen Leiterplatte verpreßt werden.

7. Verfahren nach Anspruch 5 und 6, dadurch gekennzeichnet, daß mit dem Verpressen der Anordnung bzw. Anordnungen gleichzeitig Löcher zur Befestigung von elektronischen und mechanischen Bauelementen in die Platte eingebracht werden.